# EUROPEAN PATENT SPECIFICATION

(11) **EP 4 182 979 B1**
(45) Date of publication and mention of the grant of the patent: **01.10.2025**
(21) Application number: 21745949.4
(22) Date of filing: 13.07.2021
(51) Int. Cl.: H10N 30/85, H10N 30/30, H10N 30/092, B01J 27/051, B01J 35/33, C02F 1/72

(54) **PIEZOELECTRIC AND PIEZOCATALYTIC COMPOSITE MATERIAL, AND METHODS OF USING AND FORMING IT**
PIEZOELEKTRISCHES UND PIEZOKATALYTISCHES KOMPOSITMATERIAL UND VERFAHREN ZU DESSEN VERWENDUNG UND ERZEUGUNG
MATÉRIAU COMPOSITE PIÉZOÉLECTRIQUE ET PIÉZOCATALYTIQUE ET PROCÉDÉS D'UTILISATION ET DE FORMATION ASSOCIÉS

(30) Priority: 14.07.2020 GB 202010854
(43) Date of publication of application: 24.05.2023
(73) Proprietor: UCL Business Ltd, London WC1E 6BT (GB)
(72) Inventor: TIWARI, Manish, London Greater London W1T 4TP (GB); BAGCHI, Biswajoy, London Greater London W1T 4TP (GB)
(74) Representative: Mewburn Ellis LLP
(86) International application number: PCT/EP2021/069531
(87) International publication number: WO 2022/013257

(56) References cited:
- US-A1- 2015 182 652
- US-A1- 2019 175 778
- JIANG L ET AL: "Enhanced piezoelectricity of a PVDF-based nanocomposite utilizing high-yield dispersions of exfoliated few-layer MoS2", CERAMICS INTERNATIONAL, vol. 45, no. 9, 5 March 2019 (2019-03-05), pages 11347 - 11352, XP085660350, ISSN: 0272-8842, DOI: 10.1016/J.CERAMINT.2019.02.213
- WU J M ET AL: "Piezo-Catalytic Effect on the Enhancement of the Ultra-High Degradation Activity in the Dark by Single- and Few-Layers MoS2 Nanoflowers", ADVANCED MATERIALS, vol. 28, no. 19, 18 May 2016 (2016-05-18), pages 3718 - 3725, XP055847094, ISSN: 0935-9648, DOI: 10.1002/adma.201505785
- BAGCHI B ET AL: "Re-usable self-poled piezoelectric/piezocatalytic films with exceptional energy harvesting and water remediation capability", NANO ENERGY, vol. 78, 105339, 11 September 2020 (2020-09-11), XP055846854, ISSN: 2211-2855, DOI: 10.1016/j.nanoen.2020.105339

## Description

### TECHNICAL FIELD

The present invention relates to nanocomposite piezoelectric and piezocatalytic materials; the use of these materials in water remediation; and methods of making such materials. Articles formed from or coated with these materials are also considered as part of the present disclosure, as are methods of making such articles.

### BACKGROUND

Piezoelectric materials can produce electric charge when subjected to mechanical stress and vice-versa. Mechanically straining a piezoelectric material induces an electric field throughout the material which generates free charges at its interface with the ambient environment (e.g. air or water). This electric charge can be harnessed as a means of producing electrical power from mechanical motion. For example, this effect has been suggested to be useful in wearable electronics that are powered by movement of the wearer, or harvesting "wasted" energy from sources such as acoustic vibrations.

Piezocatalytic materials are a subclass of piezoelectric materials, where the material composition is such that the free charges generated by mechanical motion in turn generate reactive oxygen species (ROS) including ^{•}OH, ^{•}O⁻, ^{•}HO₂ and H₂O₂ by local micro-electrolysis in an aqueous environment. A combination of the piezoelectric charge coupled with suitable local microstructure at the surface/interface with the aqueous environment results in this piezocatalytic behaviour. The ROS generated by mechanical actuation of the piezoelectric materials thus can be efficiently used to piezocatalytically oxidize and degrade harmful substances in the aqueous environment.

Bioaccumulation of inorganic and organic contaminants such as toxic dyes, pharmaceuticals, and drugs in wastewater effluents, natural environments and drinking waters has grown at an alarming rate in recent times and presents a huge challenge for water reuse industry. Water pollutants such as common pesticides, herbicides, organic dyes and biological contaminants such as DNA, proteins, lipids, bacteria, virus, spores etc., present a serious and persistent threat to human health. This has prompted the development of some advanced disinfection and water remediation techniques which involve reactive oxygen species (ROS). ROS consisting of a medley of strong oxidizing agents like OH•, H•, O•, O₃, H₂O₂ etc. that can safely and effectively destroy a large number of living and non-living organic contaminants in water. Among the contaminants, organic dyes are particularly challenging to remove or destroy since most dyes used in textile, pharmaceutical, food industries and agriculture are not only toxic to the environment but many are also carcinogenic. Thus, complete breakdown and/or removal of these contaminants in industry effluents and more generally in the aquatic environment is essential both for human health and for the environment. Doing this in a safe and energy-efficient manner is a major scientific challenge.

Current ROS based water treatment technologies such as UV photolysis, radiolysis, ozonation, sonochemistry, electrical discharge technology, electron-beam irradiation and supercritical water oxidation require expensive set up and a continuous energy source in the form of electricity or ultraviolet light. Although, photocatalysis has shown promise, it is limited by agglomeration tendency, post-separation difficulties and low efficiency under solar irradiation.

Piezoelectric ceramics in the form of ZnO and Cu/ZnO nanowires, Pb(Zr_{0.52}Ti_{0.43})O₃ fibers, ZnSnO₃ nanowires, single/few-layers MoS₂ nanoflowers and nano/micrometer sized BaTiO₃, etc. have all been reported to piezocatalytically degrade potentially harmful dyes e.g. Acid Orange 7, Rhodamine B, Methyl Orange, 4-chlorophenol on exposure to ultrasound vibrations. Harnessing the abundant vibrational and otherwise wasted mechanical energy to piezocatalytically treat waste water can boost water purification technology in an energy-efficient manner. However, using free piezoelectric nanoparticles directly in water treatment presents several problems in the form of stability of the nanoparticles, efficacy, accumulation, toxicity, separation and recyclability.

Piezocatalytic activity in MoS₂ nanoflowers was first reported by Wu *et al.* [1], who showed ultrafast degradation of Rhodamine B in water under dark condition. However, for practical application, the process runs the risk of contaminating water with the MoS₂ nanoparticles themselves. Furthermore, this process is not suitable for treatment of flowing water due to loss of nanoparticles over time.

Some polymers are known to demonstrate piezoelectric behaviour. For example, polyvinylidene difluoride (PVDF) is known to be piezoelectric under certain conditions. PVDF has four crystalline phases α, β, γ and δ, α being the most stable and non-polar with β and γ being polar phases due to the arrangement of the fluorine groups in the polymer chains. The β form of PVDF demonstrates the largest piezoelectric behaviour. PVDF typically exists in the α form so there is significant interest in piezoelectric research in inducing transition to the piezoelectric β phase. This can be done relatively easily by directed mechanical stretching, by electrospinning, or by application of a strong external aligned magnetic field. The process of transforming the non-piezoelectric material (e.g. α-phase PVDF) to a piezoelectric form (e.g. β-phase) is known as "poling". Alongside these processes in which energy is added in some format to achieve the poling effect (i.e. inducement of the piezoelectric behaviour), PVDF is also known to undergo "self-poling" under certain specific conditions. For example, some metal-ion doping is known to induce spontaneous formation of the β phase in PVDF [2]. However, this spontaneous self-poling in PVDF occurs only under specific conditions and with specific dopants.

Maity *et al.* [3] describes a combination of few-layer exfoliated fragments MoS₂ with electrospun PVDF to form a composite material in which the addition of few-layer MoS₂ improves the piezoelectric behaviour of the PVDF material. Jiang *et al.* [6] proposes to enhance the piezoelectric property of PVDF-based nanocomposites by combining few-layer MoS₂ nanosheets with a PVDF matrix.

Lin *et al.* [4] describes combination of MoS₂ nanoflowers with poly(dimethyl siloxane) (PDMS) to provide a material having triboelectric (generation of electric charge through relative motion between the material surface and a suitable environment) and piezocatalytic behaviour. This material was shown to degrade dyes in an aqueous environment. However significant degradation of the material was observed with repeated or extended use. Furthermore, piezocatalytic composite materials comprising nanoflowers of MoS₂, MoSe₂ or WS₂ in PDMS, for example, are known from [7].

Sahatiya *et al.* [5] describes piezoelectric and triboelectric nanogenerators comprising a layer of MoS₂ nanoflowers formed on a paper substrate with a layer of electrospun PVDF nanofibers on each side of the MoS₂ layer. The piezoelectric effect is higher than either of the individual components alone.

There remains a need for materials that address one or more of these challenges. For example, there is a desire in the art for improved robust, flexible piezoelectric nanogenerators in general. There also exists a need for effective and robust piezocatalytic materials for use in water remediation.

### REFERENCES

[1] J. M. Wu et al., Adv. Mater., 28 (2016) pp.3718-3725.
[2] N.A. Hoque et al., ACS Appl. Mater. Interfaces 9 (2017) pp. 23048-23059.
[3] K. Maity et al., Energy Technol. 5(2017) pp.234-243.
[4] J. H. Lin et al., Nano Energy 31(2017) pp.575-581.
[5] P. Sahatiya et al., Appl Mater Today, 13(2018), pp.91-99.
[6] L. Jiang et al., Ceramics International 45 (2019) pp.11347-11352.
[7] US 2019/0175778 A1

### SUMMARY

The present invention relates to a flexible, polymer nanocomposite material as a solution to overcome one or more of these limitations. As such it provides piezoelectric and piezocatalytic materials comprising MoS₂ nanoflowers embedded throughout a body comprising poly vinylidene difluoride (PVDF). Flexible piezoelectric and piezocatalytic layers, coatings or sheets formed from such materials also form part of the present invention. Piezoelectric and piezocatalytic devices incorporating these structures are also envisaged herein.

In addition, the invention provides for use of such materials, layers, coatings or sheets, for piezocatalytic removal of contaminants from an aqueous environment and/or for generation of piezoelectricity. Methods of piezocatalytic removal of contaminants from an aqueous environment, and methods of generating piezoelectricity, by application of mechanical stress to such materials, layers, coatings or sheets are also part of the invention.

A further aspect of the invention relates to methods of forming materials, layers, coatings or sheets as described herein, the method comprising intimately mixing MoS₂ nanoflowers with PVDF in a solvent to form a mixture; and then removing the solvent from the mixture.

### BRIEF DESCRIPTION OF THE FIGURES

Figure 1 shows the β phase crystallization in PVDF orienting the polymer in a (trans, trans, trans, trans) "TTTT" conformation, induced by addition of MoS₂ nanoflowers. In the PVDF, the hydrogen atoms are oriented towards, and closest to, the MoS₂ nanoflower; carbon atoms form the backbone structure surrounding the nanoflower; and the fluorine atoms are oriented away from, and furthest from, the nanoflower.
Figure 2 shows the uniform distribution of MoS₂ nanoflowers throughout a PVDF body in a device formed using materials described herein.
Figure 3 shows the XRD pattern of pure MoS₂ and the MoS₂-PVDF film prepared in Example 1.
Figure 4 shows FTIR spectra of the pure MoS₂ and the MoS₂-PVDF films formed as described in Example 1.
Figure 5 shows phase crystallization and melting behavior of pure PVDF and MoS₂-PVDF film formed as set out in Example 1 analyzed by differential scanning calorimetry (DSC) (pure PVDF on the lower spectrum and MoS₂-PVDF film on the upper spectrum).
Figure 6 shows representative FESEM images of the material formed as set out in Example 1.
Figure 7 shows the polarization-electric field (P-E) hysteresis loop measurements at 50 Hz in the ±200 kV/cm range of the material formed as set out in Example 1.
Figure 8 shows a strain vs field curve for MoS₂-PVDF material formed as set out in Example 1.
Figure 9 shows the piezoelectric output of the MPNG device formed as set out in Example 4 under periodic human finger tapping (~5 Hz).
Figure 10 shows the short circuit current (I_{sc}) corresponding to the piezoelectric output shown in Figure 9.
Figure 11 shows the variation of the output voltage and current of a device formed as set out in Example 4 across different load resistances (ranging from 1 to 40 MΩ). Voltage rising from 0 to >60V with increasing load resistance and current falling from about 5µA to near 1.5µA with increasing resistance.
Figure 12 shows power density of a device formed as set out in Example 4.
Figure 13 shows charging of a 1µF capacitor connected through a bridge rectifier to a device formed as set out in Example 4.
Figure 14 shows degradation of Acridine Orange (AO) dye in the presence of a film formed as set out in Example 1, as described in Example 7.
Figure 15 shows degradation of Eosin Y (EO) dye in the presence of a film formed as set out in Example 1, as described in Example 7.
Figure 16 shows degradation of Ethidium Bromide (ET) dye in the presence of a film formed as set out in Example 1, as described in Example 7.
Figure 17 shows degradation of Rhodamine B (RHO) dye in the presence of a film formed as set out in Example 1, as described in Example 7.
Figure 18 shows the percent dye degradation over time as set out in Example 7.
Figure 19 shows the rate of degradation curves for the dyes shown in Figure 18 as set out in Example 7.
Figure 20 shows fluorescence intensity against time as a proxy for hydroxyl radical concentration as set out in Example 7.
Figure 21 shows % Rhodamine degradation over successive tests using the same MoS₂-PVDF material, as set out in Example 7.

### FURTHER DEFINITIONS: OPTIONS; AND PREFERENCES

The present invention relates to provision of robust, flexible piezoelectric and piezocatalytic materials formed from MoS₂ nanoflowers embedded throughout a body comprising PVDF. Nanoflowers are a known morphology for some materials. As discussed herein, nanoflowers are a known structural formation having multiple sheets of material joined together and which, at a microscopic level, have the appearance of flowers. Nanoflowers differ significantly from "nanosheets" or "few-layer sheets" due to the larger scale arrangement of the sheet-like petals. Nanoflowers typically have a higher surface area to volume ratio than "nanosheets" or "few-layer sheets". Nanoflower morphologies are known for a range of materials, including MoS₂.

As discussed herein, piezoelectric behaviour is the induction of electric charge in a solid material upon application of mechanical stress. Piezoelectric materials are ones demonstrating this behaviour. Piezoelectric behaviour differs from triboelectric behaviour which relates to generation of electric charge on separation of a material from another material with which it has been in frictional contact. The materials of the present invention are piezoelectric and not triboelectric.

As discussed herein, piezocatalytic behaviour (or piezocatalysis) is the induction of catalytic activity at the interface between a solid piezoelectric material and its environment, typically an aqueous environment, resulting in catalysis of a reaction that does not typically occur in the absence of the piezocatalytic material or when the piezocatalytic material is not placed under mechanical stress. Piezocatalytic behaviour is a subset of piezoelectric behaviour. Piezocatalytic behaviour is also dependent on surface morphology; it is not purely a piezoelectric phenomenon. Therefore, demonstration of piezocatalysis is not predicatble simply due to observance of piezoelectric behaviour. Piezocatalytic materials are ones demonstrating this behaviour. One common example of piezocatalytic behaviour, and a preferable property of the materials described herein, is the degradation of water where the free charges formed at the aqueous interface in turn generate reactive oxygen species (ROS) including ^{•}OH, ^{•}O⁻, ^{•}HO₂ and H₂O₂ by local micro-electrolysis of water. The ROS generated by mechanical actuation of piezoelectric materials thus can be efficiently used to piezocatalytically oxidize and degrade contaminants in the aqueous environment, such as toxic and/or carcinogenic dyes and microbes in water from textile, chemical, pharmaceutical and food industries.

In the present invention the MoS₂ nanoflowers are preferably formed from >80 wt.% MoS₂, preferably >90 wt.% MoS₂, preferably >95 wt.% MoS₂, preferably >99 wt.% MoS₂, most preferably >99.9 wt.% MoS₂.

The MoS₂ nanoflowers are preferably broadly spherical in shape. Preferably the individual MoS₂ sheets (or "petals") are typically between 1 and 10nm in thickness. Each MoS₂ nanoflower preferably has a diameter up to 1µm; preferably up to 800nm, preferably up to 750nm, preferably up to 500nm. In some cases, each nanoflower preferably has a diameter in the range 10nm - 1µm; preferably 50nm - 1µm; preferably 200nm - 1µm, preferably 500nm-1µm.

The MoS₂ nanoflowers are preferably formed by a hydrothermal process.

Poly vinylidene difluoride (PVDF) is a polymeric material that is known to have multiple different crystalline phases α, β, γ and δ some of which demonstrate piezoelectric activity. The α phase is the most stable, is non-polar and does not exhibit piezoelectric behaviour. The β and γ phases are both polar due to the arrangement of the fluorine groups in the polymer chains, and do exhibit piezoelectric behaviour. In the present invention the PVDF is preferably in the β form. Preferably the PVDF in the present materials is >60 wt.% β phase PVDF, preferably >70 wt.%, preferably >75 wt.%, preferably >80 wt.%, preferably >85 wt.%, preferably >90 wt.%.

The PVDF used in the present invention is preferably not "poled" or subjected to a poling step before combination with the MoS₂ nanoflowers, i.e. the PVDF is "self-poled" by combination with the MoS₂ nanoflowers. In some cases the PVDF is preferably not subjected to electrospinning during the formation of the material. Preferably the poling of the PVDF in the material is achieved solely by self-poling due to interaction of the MoS₂ nanoflowers and PVDF. For example the poling of the PDVF is preferably not achieved by addition of dopant materials in addition to the MoS₂ nanoflowers.

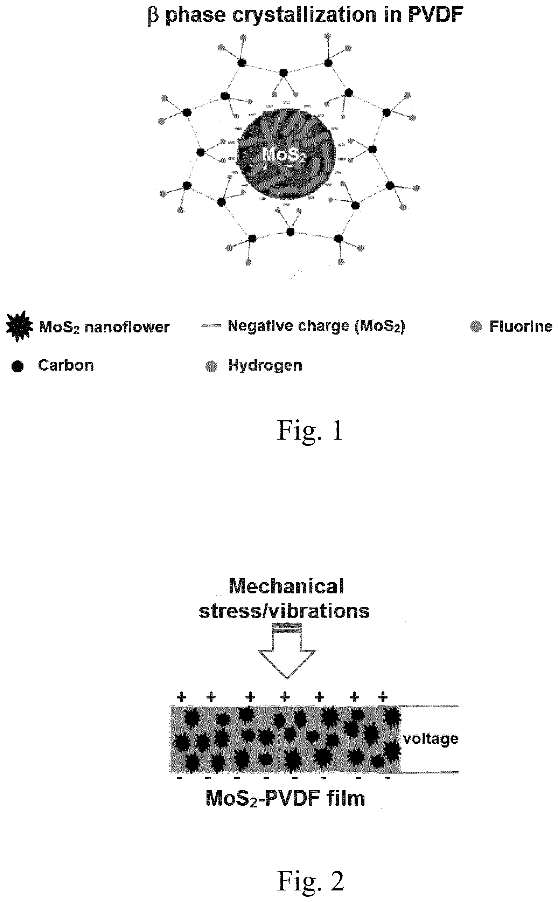

Without being bound by theory, the self-poling property may occur through either hydrogen bonding or electrostatic interaction between Mo-S dipole in non-centrosymmetric MoS₂ nanoflowers and positive-CH₂ dipole of the polymer which induces β phase crystallization by orienting the polymer in a (trans, trans, trans, trans) "TTTT" conformation as shown in Figure 1. Additionally, the -CF₂ group may also interact with Mo in the S-Mo-S moiety if PVDF occupies interstitial position in MoS₂. This interaction is further supported by FTIR analysis and a shift in the -CH₂ asymmetric and symmetric stretching band vibrations in the high frequency (υ̅ = 3050-2950 cm⁻¹) region which indicates interfacial interaction of MoS₂ layers with -CH₂/CF₂ dipoles. Furthermore, since MoS₂ nanoflowers with abundant single and few layers exhibit piezoelectric potential at the edge sites, their incorporation in PVDF is thought to contribute to the overall piezoelectricity of the composite materials proposed herein. However, in preferred materials herein, the piezoelectric charge is significantly higher than would be expected from the behaviour of PVDF and MoS₂ nanoflowers alone, indicating a synergistic effect.

The PVDF used in the present invention preferably has a mass average molecular weight (M_{w}) determined by Gel Permeation Chromatography (GPC), in the range 50,000 - 800,000; preferably 100,000 - 500,000, preferably 100,000 - 250,000, preferably 150,000 - 200,000, preferably about 180,000.

The PVDF used in the present invention preferably has a number average molecular weight (Mₙ) determined by GPC, in the range 10,000 - 200,000; preferably 20,000 - 150,000, preferably 35,000 - 100,000, preferably 50,000 - 100,000, preferably about 71,000.

The present invention provides a material in which MoS₂ nanoflowers are combined with PVDF. The MoS₂ nanoflowers are embedded throughout the PVDF body; they are not confined to a discrete layer or region within the material. Preferably the distribution of MoS₂ nanoflowers though the PVDF is substantially uniform (as shown in Figure 2).

The present materials necessarily contain some level of MoS₂ nanoflowers to achieve the desired effects. Preferably the materials contain up to about 20 wt.% MoS₂ nanoflowers. Above about 20 wt.% the material can start to shed MoS₂ nanoflowers on physical manipulation (e.g. bending, friction with adjacent materials etc.). This can be detrimental in applications such as water remediation where shedding of MoS₂ nanoflowers into the water presents additional contamination of the water and is problematic to remove. Preferably the material contains up to about 20 wt.% MoS₂ nanoflowers based on the weight of MoS₂ nanoflowers and PVDF, preferably in the range 5-20 wt.%, preferably in the range 10-20 wt.%, preferably in the range 10-15 wt.%, preferably about 10 wt.%. Formation of β phase PVDF starts to occur at and above about 5 wt.% MoS₂ content, below 5 wt.% the amount of β phase PVDF observed is very low.

In some cases, the PVDF may be present as a component in a co-polymer or a polymer mixture. For example the PVDF may be present as part of a copolymer system with a second polymer, preferably a piezoelectric polymer. In some cases the PVDF is present as part of a copolymer system selected from PVDF-HFP (poly(vinylidene fluoride-co-hexafluoropropylene)) and PVDF-TrFE (polyvinylidene fluoride-trifluoroethylene).

The present materials, preferably include at least 50 wt.% PVDF based on the weight of the total material; preferably at least 75 wt.%, preferably at least 80 wt.%, preferably at least 85 wt.%, preferably about 90 wt.%, preferably about 95 wt.%.

In aspects where PVDF is present as part of a copolymer system, the present materials, preferably include at least 50 wt.% PVDF copolymer based on the weight of the total material; preferably at least 75 wt.%, preferably at least 80 wt.%, preferably at least 85 wt.%, preferably about 90 wt.% , preferably about 95 wt.%.

In some preferred cases, the material consists of only MoS₂ nanoflowers and PVDF; or consists essentially of only MoS₂ nanoflowers and PVDF (i.e. other components are negligible contaminants having no significant effect on the properties of the material).

In the present invention the MoS₂ nanoflowers are embedded throughout a body comprising poly vinylidene difluoride (PVDF). In preferred cases, the body consists of, or consists essentially of, PVDF or a PVDF copolymer, preferably PVDF.

In the present materials, the provision of MoS₂ nanoflowers embedded throughout a body comprising PDVF results in a material that demonstrates piezoelectric properties and piezocatalytic properties.

Typically the MoS₂ nanoflowers and PVDF interact in a synergistic manner to provide one or both of piezoelectric and piezocatalytic activity at a higher level that would be expected from the properties of MoS₂ nanoflowers and PVDF alone and from the properties of known materials containing MoS₂ in other morphologies and PVDF. This synergistic behaviour may, for example, manifest in one or more of, particularly high piezoelectric voltage for a given pressure, particularly effective piezocatalytic behaviour, particularly robust materials, and particularly long-lasting piezocatalytic behaviour.

While composite materials of few-layer MoS₂ sheets and PVDF are known, these do not display piezocatalytic properties; they do not, for example, degrade dyes in an aqueous environment as effectively as the materials of the present invention. Furthermore, the piezoelectric properties of such known systems are significantly worse than the materials of the present invention. For example the piezoelectric open-circuit voltage under for a given mechanical stress is significantly higher for the materials of the present invention than for those in which MoS₂ sheets are used in combination with PVDF.

While composite materials of MoS₂ nanoflowers and PDMS are known, these do not display piezoelectric properties; displaying instead triboelectric activity. Furthermore the open-circuit voltage generated is significantly higher for the materials of the present invention than for those in which MoS₂ nanoflowers are used in combination with PDMS. In addition, the composite materials of MoS₂ nanoflowers and PDMS degrade with repeated use as compared to those of the present invention which retain piezocatalytic behaviour over at least 10 cycles of water treatment.

While layered materials comprising a MoS₂ nanoflower layers sandwiched between electrospun PVDF layers are known, the piezoelectric properties of such known systems are significantly worse than the materials of the present invention. For example, the piezoelectric open-circuit voltage under for a given mechanical stress is significantly higher for the materials of the present invention than for those in which MoS₂ nanoflower layers sandwiched between electrospun PVDF layers. Furthermore the electrospinning of the PVDF layers that is required to achieve poling in these known systems, adds complexity and energy requirements to the manufacturing steps and limits the shape and applications of devices formed from the material.

The materials of the present invention may contain other components alongside the MoS₂ nanoflowers and PVDF. Such other components, if present, are selected so as not to negatively impact the piezoelectric and piezocatalytic properties of the materials. The other components are not particularly limited and may include one or more of the following, colourants, stabilisers, and fillers. Surface coatings applied over the material may act as a barrier to the interaction of the material with the environment so are preferably avoided.

The materials described herein may be used to form a variety of structures. Preferably the materials herein are used to form a coating, layer or sheet. Such thin structures are preferred, particularly for energy harvesting applications because they are typically flexible meaning that they can be easily incorporated into products that experience high levels of mobility during use, e.g. energy harvesting clothing. Many piezoelectric materials are relatively rigid solids, e.g. ceramics, so this flexibility provides a significant advantage in such products because it avoid imparting unwanted rigidity into the product. In some cases, the materials described herein are preferably prepared as a coating, layer or sheet, optionally on an electrically inert substrate. Optionally the coating, layer or sheet has a thickness of 2mm or less, preferably 1mm or less, preferably 750µm or less, preferably 500 µm or less, preferably 250µm or less, preferably 100µm or less, preferably about 50µm. In some cases it is preferred to have a lower limit on the thickness of about 1µm, preferably about 10µm, preferably about 25µm. Optionally, a coating, layer or sheet as described herein may be used with a suitable adhesion promoter or primer, e.g. as a backing layer, to improve adhesion and robustness.

An advantage of the present materials is that they can be used to form products of essentially any shape by using a casting process. For example monolithic structures can be formed that have piezoelectric and piezocatalytic properties. The materials described herein can be used in this way because they have a uniform composition throughout the material. They are also formed from a uniform mixture by a casting process. In the materials described herein, a specific arrangement of components, e.g. layers of MoS₂ particles sandwiched between PVDF sheets, is not required to achieve the desired piezoelectric and piezocatalytic properties. This represents a significant advantage of the materials described herein.

The materials described herein demonstrate beneficial piezoelectric properties, for example:
1) In preferred aspects, the materials demonstrate notably high piezoelectric open circuit voltage. For example the open circuit voltage under an applied stress of 60-70kPa (about human finger-tapping pressure) is preferably above about 50V preferably above about 60V, preferably above about 70V, preferably above about 80V.
2) The power density of the materials described herein under an applied stress of 60-70kPa (about human finger-tapping pressure) is preferably greater than about 20 mW/cm³, preferably greater than about 30 mW/cm³, preferably greater than about 35 mW/cm³, preferably greater than about 40 mW/cm³, preferably greater than about 45 mW/cm³.
3) The short circuit current of the materials described herein under an applied stress of 60-70kPa (about human finger-tapping pressure) is preferably greater than about 0.5 µA, preferably greater than about 1.0 µA, preferably greater than about 1.5 µA, preferably greater than about 2.0 µA, preferably greater than about 2.5 µA, preferably greater than about 3.0 µA.

In some preferred aspects the materials described herein demonstrate one, two or all three of the preferred piezoelectric characteristics 1-3 listed above.

The materials described herein demonstrate beneficial piezocatalytic properties, for example:
1) The materials described herein preferably degrade a range of dyes (to >90% degradation), including at least one of Acridine Orange, Eosin Y, Ethidium Bromide and Rhodamine in aqueous solution, under ultrasonic vibration in the dark in less than 45 minutes, preferably less than 40 minutes, preferably less than 35 minutes, preferably less than 30 minutes, preferably less than 25 minutes, preferably less than 20 minutes, preferably less than 15 minutes.
2) The materials described herein preferably degrade a range of dyes (to >90% degradation), including at least one of Acridine Orange, Eosin Y, Ethidium Bromide and Rhodamine in aqueous solution, under ultrasonic vibration in the dark following pseudo first order kinetics having a rate constant preferably greater than 0.1 min⁻¹, preferably greater than 0.2 min⁻¹, preferably greater than 0.25 min⁻¹, preferably greater than 0.3 min⁻¹.
3) The materials described herein are preferably effective to degrade one or more contaminants in aqueous solution in the dark, under applied mechanical stress, the contaminants being selected from, dyes, pesticides, pharmaceuticals, microbes, organic waste products from the pharmaceutical, agrochemical, dyestuff, textile, chemical, or food industries.

The materials described herein offer particular benefits in water remediation, i.e. removal of contaminant species from aqueous environments. This is demonstrated by the excellent activity in removal of Ethidium bromide, Eosin Y, Rhodamine B and Acridine Orange dyes. To date, degradation of these dyes has been mainly limited to using photocatalytic nanoparticles (such as ZnO, TiO₂, SnO₂, Fenton's reagent, Au and Ag) under light irradiation. In contrast, the MoS₂-PVDF materials described herein achieve this degradation through a fast-piezocatalytic process which harnesses vibrational energy to degrade the dyes under dark conditions. Such activity is suitable, for example for treatment of industrial effluents flowing through pipelines.

The present invention also relates to the preparation of a piezoelectric and piezocatalytic device using the materials described herein. Such a device may be formed by providing a sheet of the MoS₂-PVDF composite material described herein and sandwiching it between two electrodes. These electrodes can be as simple as pieces (e.g. sheets) of electrically conducting material that act as a conduit for the electrical charges that build up at the surfaces of the composite material during mechanical stressing. Preferably the electrodes are formed from two sheets of electrically conducting material selected from copper, aluminium, silver, and gold, each having a wire in electrical contact with it to conduct the electrical charge away from the device.

The present invention also relates to the use of materials, layers, coatings, sheets and devices as described herein for piezocatalytic removal of contaminants from an aqueous environment. For example, this can be achieved by placement in an aqueous environment in need of remediation and subsequently applying mechanical stress, preferably repeatedly applying mechanical stress. Examples may include removal of contaminants from industrial effluent, e.g. by placement on an interior surface of an industrial effluent pipe, removal of contaminants from drinking water, removal of pathogens such as harmful microbes, from water that is to be used for drinking or washing.

Methods of piezocatalytic removal of contaminants from an aqueous environment also form part of the present invention, the methods comprising contacting the aqueous environment with a material, layer, coating, sheet or device as described herein, and applying mechanical stress to said material, layer, coating, sheet or device.

The present invention also relates to the use of materials, layers, coatings, sheets and devices as described herein for generation of piezoelectricity. For example, this can be use in the harvesting of energy from mechanical motion. In some cases this may be incidental mechanical motion, i.e. motion that is inherent in the system and not deliberately applied or induced solely for the purpose of energy generation. Other examples are incorporation into clothing to harvest energy from human body motion, harvesting energy from ambient vibrations in the environment, e.g. acoustic vibrations, harvesting energy from liquid flowing over the nanocomposite, harvesting energy from impact and tapping forces.

Methods of generating piezoelectricity also form part of the present invention, the methods comprising providing a material, layer, coating, sheet or device as described herein, and applying mechanical stress to said material, layer, coating, sheet or device.

Methods of forming materials as described herein also form part of the present invention, the methods comprising intimately mixing MoS₂ nanoflowers with PVDF in a solvent to form a mixture; and then removing the solvent from the mixture. In these methods, the solvent is not particularly limited; it is preferably selected from dimethyl sulfoxide (DMSO), DMF (dimethyl formamide), NMP (N-methyl pyrollidone), and DMAc (Di methyl acetamide), preferably it is DMSO.

The step of intimately mixing the MoS₂ nanoflowers with PVDF is not particularly limited as long as it achieves a reasonably uniform distribution of the MoS₂ nanoflowers throughout the body of PVDF; simple stirring to achieve complete dispersion of the MoS₂ nanoflowers is preferred.

The methods may also include a step prior to removal of the solvent, of placing the mixture into a mold or applying as a layer to a surface. This allows formation of any desired shape of the material; something that is not achievable with some known piezoelectric and/or piezocatalytic materials, particularly where the known materials use layered structures. Preferably the methods include a step of applying the mixture as a layer on a surface prior to removal of the solvent.

The removal of solvent may be achieved by one or more of heating, reducing pressure, or simply leaving the solvent to evaporate under ambient temperature and pressure. In some cases, particularly for thin layers, the step of removing the solvent from the mixture is passive, i.e. simply leaving the solvent to evaporate under ambient temperature and pressure. In some cases the step of removing the solvent comprises heating, e.g. heating to a temperature in the range 50-100°C, such as 80°C under ambient pressure. Removal of solvent by heating typically results in higher levels of β phase PVDF formation than evaporation at ambient temperature, therefore removal of solvent by heating is preferred.

Preferably the methods do not include a step of electrospinning. Preferably the methods do not include a step of electrospinning of the PVDF. Preferably the present methods do not include a step of poling the PVDF before combination with the MoS₂ nanoflowers, i.e. the step of combining the PVDF with the MoS₂ nanoflowers results in "self-poling" of the PVDF. For example the methods preferably do not include the addition of dopant materials in addition to the MoS₂ nanoflowers to PDVF.

### EXAMPLES

The following examples are provided by way of illustration of the present invention and do not limit the present invention.

Physico-chemical characterisation including phase formation, microstructure, elemental distribution and thermal properties of MoS₂ nanoflower and MoS₂-PVDF film was performed using X-ray diffraction (XRD; Model-D8, Bruker AXS Inc., Madison, WI), Fourier transform infrared (FTIR) spectroscopy (FTIR-8400S, Shimadzu), Field emission scanning electron microscopy (FESEM; INSPECT F50, Netherlands), Energy dispersive x-ray analysis (EDAX) and Differential scanning calorimetry (DSC-60, Shimadzu). Ferroelectric properties of the film were measured in terms of polarization-electric field (P-E loop) using Hysteresis version 4.9.0 (Radiant technologies).

Open circuit voltage (V_{oc}) generated by the MPNG under continuous finger imparting and ultrasound was measured using a digital storage oscilloscope (Keysight, Oscilloscope DSO-X 3012A). Short circuit current (I_{sc}) was recorded under the same condition using Keysight, Electrometer B2985.

Catalytic degradation of dyes was monitored using a UV-Visible spectrophotometer (Lambda 650, Perkin Elmer) and •OH was measured with terephthalic acid (Merck, Germany) using a Cary Eclipse Fluorescence spectrophotometer (Agilent Technologies).

### Example 1

### Synthesis of MoS₂ nanoflowers

MoS₂ nanoflowers were synthesized by hydrothermal process. 0.28 g of Pluronic F-127 (Merck, Germany) was dissolved in 140 mL of distilled water. Next 8.5g of Ammonium heptamolybdatetetrahydrate, (NH₄)₆Mo₇O₂₄.4H₂O, (Merck, Germany) and 1.28 mg Thiourea, CH₄N₂S, (Merck, Germany) were added to the solution and stirred at room temperature for 30 min. The resulting homogeneous solution was then loaded in a stainless-steel Teflon lined hydrothermal reactor and was kept in an oven at 200°C for 24 h. After the reaction, the black precipitate was centrifuged and washed with water and alcohol repeatedly. The precipitate was then dried to get a free-flowing powder and stored for further characterization and use.

### Synthesis of MoS₂-PVDF films

MoS₂ nanoflower doped PVDF film was fabricated using solution processing. 250 mg of PVDF (Sigma-Aldrich, Germany; Mw: 180,000 GPC; Mn: 71000) was dissolved in 60 mL of Dimethyl sulfoxide (DMSO) (Merck, Germany) under constant magnetic stirring at 60°C to obtain a homogeneous solution. Next, MoS₂ (10 wt% of PVDF) powder was added to the PVDF solution and continuously stirred at room temperature until complete dispersion was achieved. Afterwards, the colloidal suspension was transferred to a clean petri dish and dried at 80°C in an oven to produce a nanocomposite film.

For comparison, pure PVDF film was also prepared in the same way but without MoS₂ nanoflowers.

### Example 2

### XRD analysis

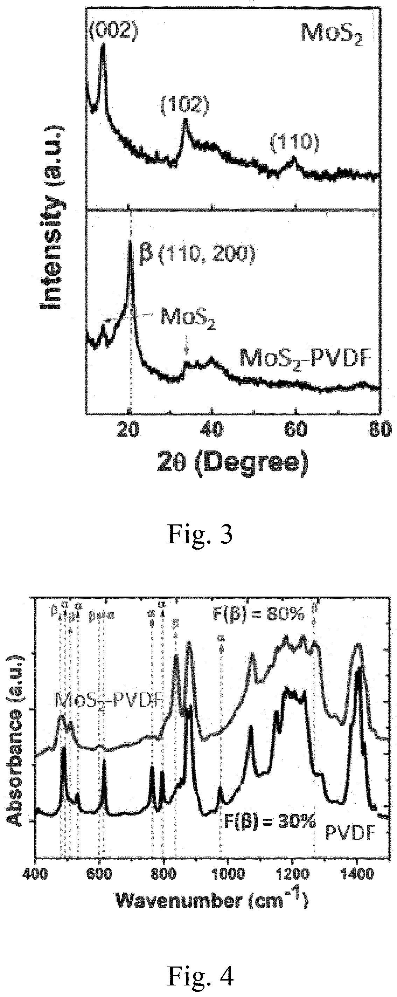

The XRD pattern of pure MoS₂ and the MoS₂-PVDF film prepared in Example 1 is shown in Figure 3.

MoS₂ shows characteristic broad reflections at 13.97° (002), 33.66° (102), 39.97° (103), 49.94° (105) and 59.41° (110) which confirms phase formation in the as synthesized powder.

In the MoS₂-PVDF film, addition of MoS₂ nanoflowers significantly promotes nucleation of polar electroactive β-crystals in PVDF film which is indicated by a sharp single peak at 20 = 20.5° ((110), (200)) and absence of α phase reflections. In addition, reflections corresponding to MoS₂ are also present indicating the composite nature of the film.

### FTIR analysis

FTIR spectra of the pure MoS₂ and the MoS₂-PVDF films formed as in Example 1 shown in Figure 4. This analysis also indicates enhanced electroactive β phase formation in the composite film.

Pure PVDF (lower spectrum in Figure 4) shows characteristic absorbance bands of nonpolar α-crystals at 488 cm⁻¹ (CF₂ waging), 532 cm⁻¹ (CF₂ bending), 615 and 764 cm⁻¹ (CF₂ bending and skeletal bending), and 796 and 976 cm⁻¹ (CH₂ rocking).

In case of MoS₂-PVDF (upper spectrum in Figure 4), all of the characteristic peaks corresponding to nonpolar α-crystals are absent with absorbance bands at 445 cm⁻¹ (CF₂ rocking and CH₂ rocking), 479 cm⁻¹ (CF₂ deformation), 510 cm⁻¹ (CF₂ stretching), 600 cm⁻¹ (CF₂ wag), and 840 and 1274 cm⁻¹ becoming predominant. The appearance of 510 cm⁻¹ and 840 cm⁻¹ band along with 445 cm⁻¹ and 1274 cm⁻¹ bands and the absence of the characteristic absorbance band of γ crystals at 1234 cm⁻¹ confirms nucleation of electroactive β-crystals in the MoS₂ doped PVDF film. Presence of MoS₂ was confirmed from the vibrations around 480 cm⁻¹ (Mo-S stretching), 900 cm⁻¹ (S-S stretching) and 1100 cm⁻¹ (O-H stretching) which almost merges with the PVDF bands.

The fraction of electroactive β phase content in the nanocomposite MoS₂-PVDF film was calculated by using the Lambert-Beer Law. Using this equation, the β phase crystallization in pure PVDF is found to be 30% whereas for MoS₂-PVDF it reached 80%. Since the piezoelectric nature of PVDF is strongly dependent on the amount of electroactive β phase, therefore the addition of MoS₂ nanoflowers clearly enhances its piezoelectric properties.

### DSC thermograph analysis

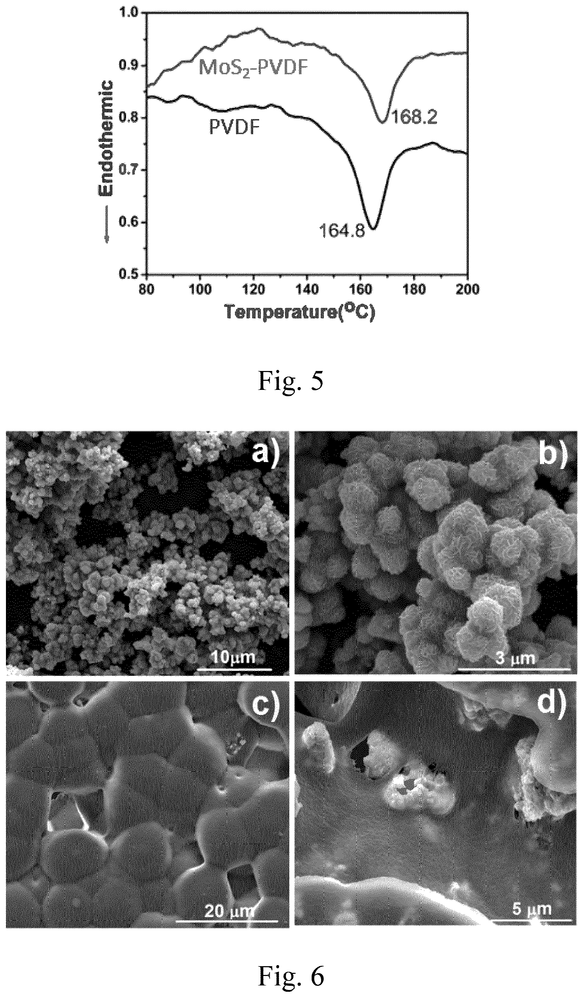

The phase crystallization and melting behavior of pure PVDF and MoS₂-PVDF film formed as set out in Example 1 was also analyzed by differential scanning calorimetry (DSC) to complement XRD and FTIR measurements. Results are shows in Figure 5 (pure PVDF on the lower spectrum and MoS₂-PVDF film on the upper spectrum).

The melting peak at 164.5 °C in the DSC thermograph of pure PVDF film indicates presence of nonpolar α polymorph, whereas for the MoS₂ nanoflower-doped PVDF, the melting peak is shifted to a higher temperature indicating the nucleation of electroactive β phase in the nanocomposite film. The enthalpy of fusion and crystallinity both increased upon MoS₂ nanoflower doping; MoS₂-PVDF film had X_{c} ≈ 53.43% compared to X_{c} ≈ 33% for pure PVDF. This change is due to interaction between MoS₂ nanoflowers and the polymer resulting in the formation of β-crystals in the nanocomposite film.

### Example 3

### Field Emission Scanning Electron Microscopy (FESEM) imaging

The morphology of the piezoelectric films formed as set out in Example 1 was assessed by FESEM and representative images shown in Figure 6. MoS₂ nanoflowers are spherical in shape with particle size of ~0.8µm (Figure 6a). A magnified image (Figure 6b) clearly shows that each particle has flower like morphology characteristic of single and few-layers MoS₂.

MoS₂-PVDF material (formed as in Example 1) shows distinct formation of spherulites of diameter ~5-8 µm which confirms β phase crystallization (Figure 6c). The fracture surface of the MoS₂-PVDF films shows the presence and distribution of MoS₂ nanoflowers in the PVDF matrix (Figure 6d). Most of the MoS₂ is found to be embedded inside the polymer with very little fraction exposed to the environment at porous regions on the surface of the film. Elemental mapping and EDAX confirmed a homogeneous distribution of nanoflowers observed throughout the film which indicates uniform dispersion and interaction with PVDF.

### Example 4

### MoS₂-PVDF nanogenerator (MPNG) fabrication

A nanogenerator was fabricated by using an MoS₂-PVDF film of dimension 1 cm × 1 cm × 50 µm formed as set out in Example 1. A 40 µm thick copper/aluminium electrode was attached to each side of the film and with a copper wire attached to each electrode. Next, the film containing the electrodes and connecting wires was packaged in polydimethylsiloxane (PDMS) (Sylgard 184, Dow Corning, ratio of 1:10) by immersing the nanocomposite films in PDMS gel and drying for 15 min in a vacuum followed by drying at 60°C for 1 h to remove bubbles from the mixture. The final package size of the as-fabricated MPNG device was 2 cm × 2 cm × 0.3 cm.

### Example 5

### Ferroelectric characterization

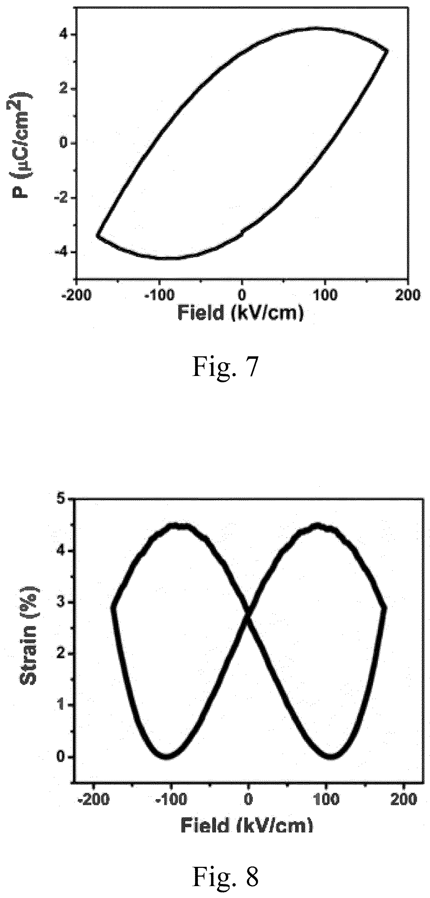

Ferroelectric properties of MoS₂-PVDF film formed as set out in Example 1 were determined from the room-temperature polarization-electric field (P-E) hysteresis loop measurements at 50 Hz in the ±200 kV/cm range. The area within the loop corresponds to heterogeneous charge density and indicates charge storage capability of the material. As can be seen from Figure 7, the MoS₂-PVDF film shows a strong Remnant polarization (Pr) value of 3.38 µC cm⁻² compared to pure PVDF (0.038 µC cm⁻² at 100 Hz). This high Pr value indicates good reversible ferroelectric behaviour and accelerated heterogeneous polarization tendency in the film. It also indicates that the material is inherently polar and piezoelectric in nature. Since no poling step was used in the synthesis process of Example 1, this confirms the self-poling of these nanocomposite films.

The piezoelectric coefficient (d₃₃) of MoS₂-PVDF is calculated to be -36.4 pC/N. This value is higher than observed in poled PVDF (-24 pC/N) showing that the composite film has superior piezoelectric properties to poled PVDF but without undergoing any specific poling step.

A strain vs field curve was also plotted for MoS₂-PVDF and is shown in Figure 8. This shows a characteristic butterfly loop nature and confirms the reversible polarization and converse piezoelectric behaviour of the nanocomposite film.

The characterisation of the MoS₂-PVDF film confirms the self-poling that is inherent in the formation method and confirms the piezoelectric behaviour feature of the MoS₂-PVDF nanocomposite.

### Example 6

### MoS₂-PVDF nanogenerator (MPNG) performance

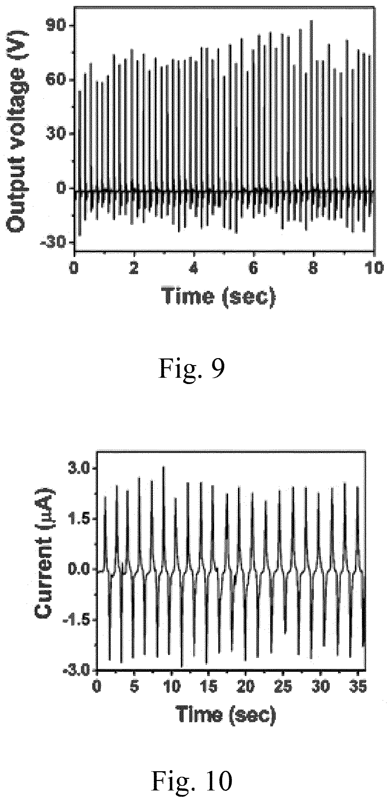

Figures 9-13 show the nanogenerator functionality of the MoS₂-PVDF nanogenerator formed in Example 4.

The piezoelectric output of the MPNG device under periodic human finger tapping (~5 Hz) is shown in Figure 9. An impressive open circuit voltage (V_{oc}) of 84V is obtained under a tapping force of 27.5 N (64.5 kPa). The corresponding short circuit current (I_{sc}) is shown in Figure 10 and reached a value of 3.05 µA.

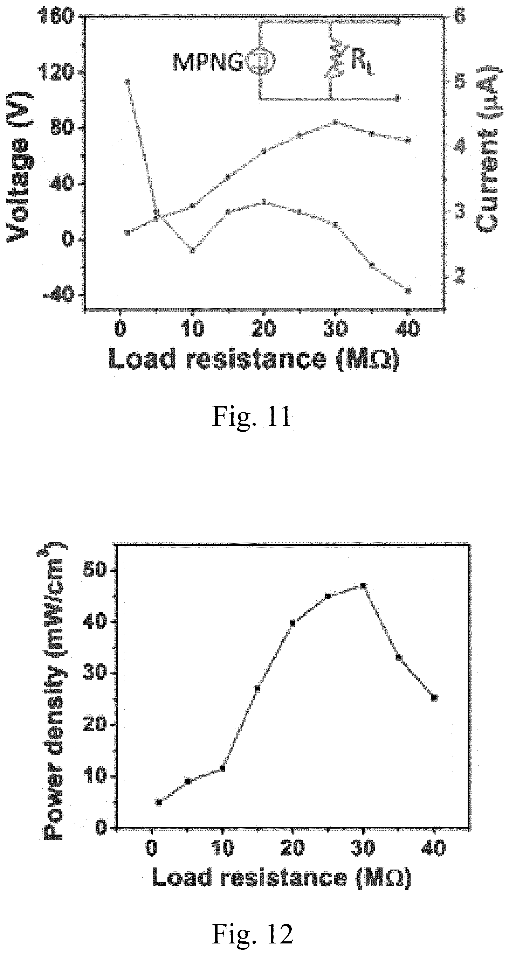

The variation of the output voltage from MPNG was further evaluated across different load resistances (ranging from 1 to 40 MΩ); the instantaneous voltage increased and gradually reached a peak value of 84 V at 30 MΩ similar to open voltage circuit (V_{oc}) (Figure 11). The device gave an outstanding peak power density of 47.14 mW cm⁻³ at 30 MΩ load (Figure 12). The MPNG device of Example 4 also produced an output of 2V when immersed in an ultrasonic bath (100 W) indicating high sensitivity and piezoelectric behaviour over a wide range of frequencies.

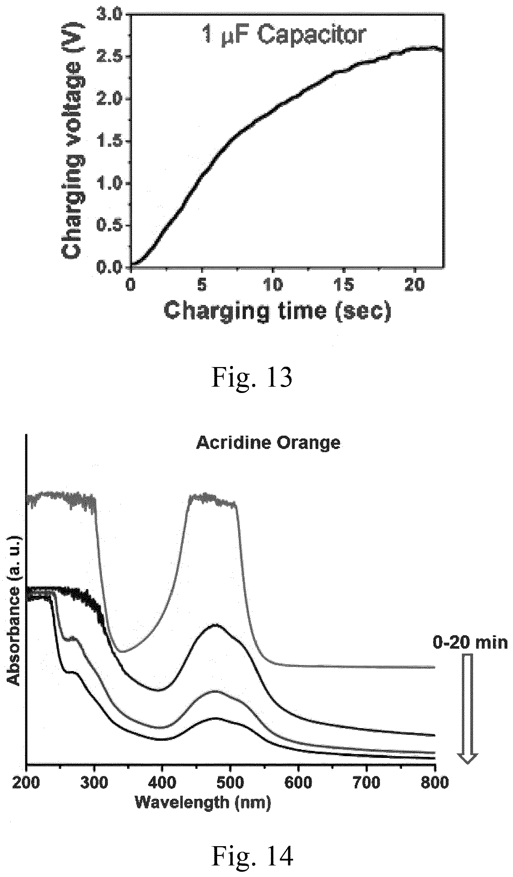

To demonstrate the application potential of the MPNG of Example 4, it was connected to a 1µF capacitor through a bridge rectifier. As shown in Figure 13, the capacitor is charged very swiftly to 2.5 V within 20 s under finger tapping. Further, the device was able to power up 25 commercial LEDs when connected in series through a full wave bridge rectifier indicating sufficient piezoelectric capacity to be a viable candidate for portable self-powered electronic and medical devices.

### Comparative Example 1

A comparison of the MPNG device of Example 4 with other previously reported PVDF based nanogenerators is summarized in table 1.

**Table 1**

| **Nanogenerator** | **Poling Status** | **Voltage (V)** | **Current (I)** | **Power Density** | **Pressure** | **Dimensions (Area × thickness)** |
|---|---|---|---|---|---|---|
| PVDF/AlO-rGO | Self-poled | 36 V | 0.8 µA | 27.97 µW/ cm³ | 36 kPa | 7.82 cm² × 0.13 cm |
| rGO-Ag/PVDF | Self-poled | 18V | 1.08 µA | 28 µW/cm³ | NA | 22 cm² × N.A. |
| Fe-rGO/PVDF | Self-poled | 5.1V | 0.254 µA | N.A. | 12 kPa | 6 cm² × N.A. |
| ZnO NWs/PVDF | 100 kV/mm | 0.2 V | 10 nA | 2 µW/cm³ | N.A. | N.A. |
| Nano ZnO/PVDF (0.2M ZnO loading) | 5 MV/m | 4 V | N.A. | N.A. | 4.4 kPa | 0.25 cm² × 10 µm |
| Cerium complex-PVDF | Self-poled | 36 V | N.A. | N.A. | N.A. | 3.75 cm² × N.A. |
| γ-PVDF/ZnO | Self-poled | 28 V | 450 nA | 0.4 µW/cm³ | 8.43 kPa | 7.2 cm² × N.A. |
| PVDF/DNA | Self-poled | 20 V | 0.184 µA | 11 µW/cm² | 63 kPa | N.A. |
| BaTiO₃-PVDF | 2 kV | 35 V | 600 nA | NA | 1 MPa | 1 cm² × N.A. |
| FAPbBr₃-PVDF | 50 kV/cm | 30 V | 6.2 µA | 27.4 µW/cm² | 0.5 MPa | **1.68** cm² × N.A. |
| PVDF/ 2D-MoS₂ | 10 kV | 14V | N.A. | N. A. | 8.8 kPa | N.A. |
| PVDF/few layer MoS₂-cellulose | 18 kV | 50 V | 30 nA | N.A. | N.A. | 9 cm² × N.A. |
| PVDF/ZnO (*in situ*) | Self-poled | 50 V | 3.05 µA | 32.8 mW/cm³ | 70 kPa | 0.64 cm² × 20 µm |
| Niobate/PVDF | Self-poled | 18V | 2.6 µA | N.A. | 125 kPa | 4 cm² × N.A. |
| **MPNG of Example 4** | **Self-poled** | **84V** | **2.8 µA** | **47.14 mW/cm³** | **67.5 kPa** | **1 cm²× 50 µm** |

A pure PVDF-based nanogenerator produced only 4V under the same tapping force.

A comparison of capacitor charging ability of the MPNG device of Example 4 with other previously reported PVDF based nanogenerators is also summarized in table 2.

**Table 2**

| **Nanogenerator** | **Capacitor (µF)** | **Time required (s)** |
|---|---|---|
| PVDF/AlO-rGO | 2.2 | 96.6 |
| Cerium complex-PVDF | 1 | 70 |
| γ-PVDF/ZnO | 1 | 100 |
| PVDF/DNA film | 2.2 | 230 |
| FAPbBr₃-PVDF | 3.3 | 200 |
| PVDF/ 2D-MoS₂ | 1 | 44 |
| PVDF/ZnO (*in* s*itu*) | 1 | 13 |
| Yb³⁺/ PVDF | 1 | 30 |
| P(VDF-HFP)/Zn²⁺ film | 1 | 70 |
| **MPNG of Example 4** | 1 | 20 |

### Example 7

### Piezcatalysis characterisation

*A MoS₂-PVDF* nanocomposite film formed according to Example 1, having dimensions 2 cm × 2 cm and thickness 50 µm was immersed in 10 mL of 10 ppm solutions of each of the following dyes (all Loba chemie) in deionised water.
Acridine Orange (AO)
Eosin Y (EO)
Ethidium Bromide (ET)
Rhodamine B (RHO)

The conical flask containing the dye solution and the nanocomposite film was placed in a bath sonicator (RS Pro Ultrasonic Cleaner, 100W) and subjected to pulsed ultrasonic vibrations for 20 mins. A small portion of the dye solution was pipetted out at regular intervals (0, 5, 10, 15 and 20 min) and measured using UV-Visible spectrophotometer to check degradation. The percent degradation and the rate constant were calculated from the measured data.

A recyclability test was also performed with Rhodamine B which included 10 cycles of catalytic tests using 200 mL of 10 ppm dye concentration to determine the efficacy of the MPNG film for treating large volumes of water.

All the catalytic experiments were carried out in dark at 25 °C.

### Piezocatalytic dye degradation

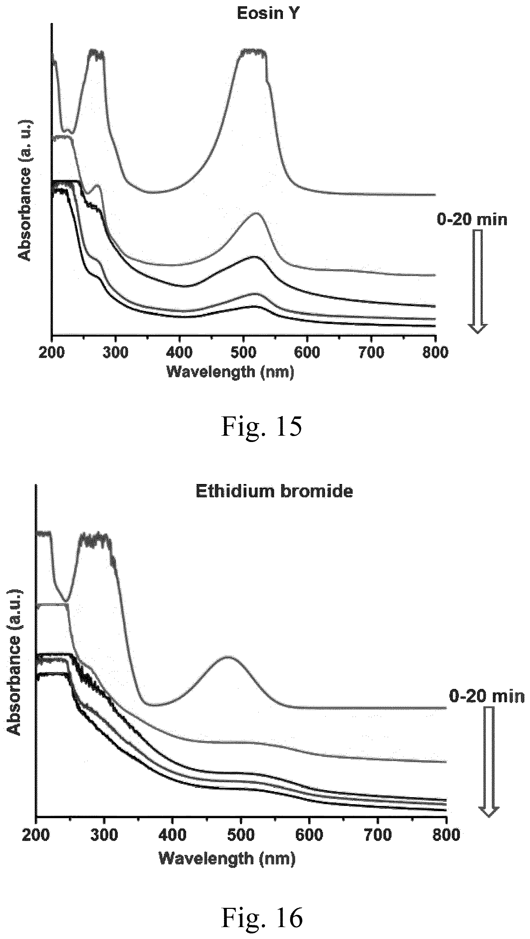

Piezocatalytic dye degradation was monitored using UV-Visible spectroscopy. Results are presented in Figures 14-17.

As can be seen all dyes showed rapid degradation within 20 minutes of ultrasonication with the nanocomposite MoS₂-PVDF film formed as in Example 1 under in dark conditions. The degradation was also visually observed from the change in dye colour after 25 minutes of ultrasonication thereby clearly demonstrating piezocatalytic activity.

In contrast, pure PVDF film failed to any appreciable degradation of dyes even after prolonged sonication (50 mins).

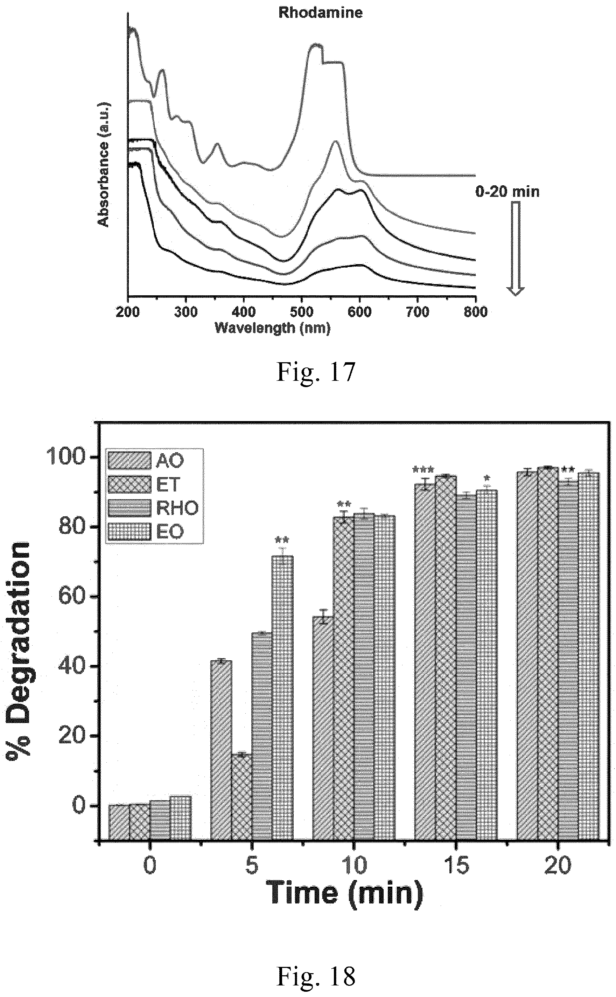

The percent degradation over time is presented in Figure 18, where the MoS₂-PVDF film formed as in Example 1 shows excellent catalytic activity in dark with >90% degradation achieved for each dye. However, with an undoped PVDF film, the amount of dyes remained unchanged even after prolonged ultrasonication which indicates that the piezoelectric effect in MoS₂-PVDF film is playing a major role in the catalytic process.

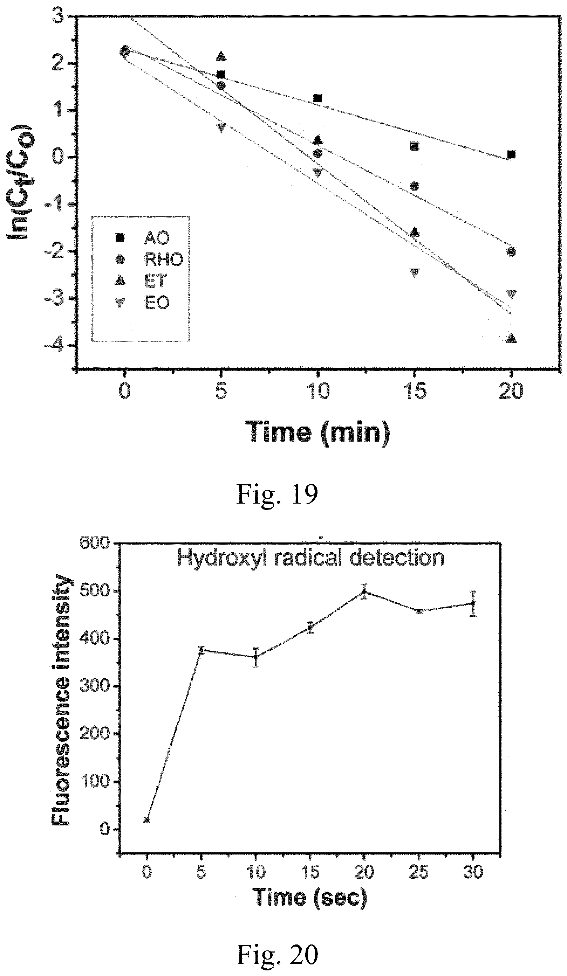

The degradation reaction followed pseudo first order kinetics as indicated from the rate of degradation curve (Figure 19). The highest rate constant was achieved for Ethidium bromide (ET) (0.32 min⁻¹) followed by Eosin Y (0.26 min⁻¹), Rhodamine B (0.21 min⁻¹) and Acridine Orange (0.127 min⁻¹), respectively. To date, degradation of these dyes has been mainly limited to using photocatalytic nanoparticles (ZnO, TiO₂, SnO₂, Fenton's reagent, Au and Ag etc.) under light irradiation.

Terephthalic acid forms a fluorescent hydroxyterephthalic acid upon reaction with ^{•}OH radical, which offers qualitative means to detect the radical formation with high sensitivity. Figure 20 shows the fluorescence intensity as a proxy for hydroxyl radical concentration. It can be observed that ^{•}OH radical is being gradually generated with time after ultrasound exposure reaching a stable value around 20 minutes.

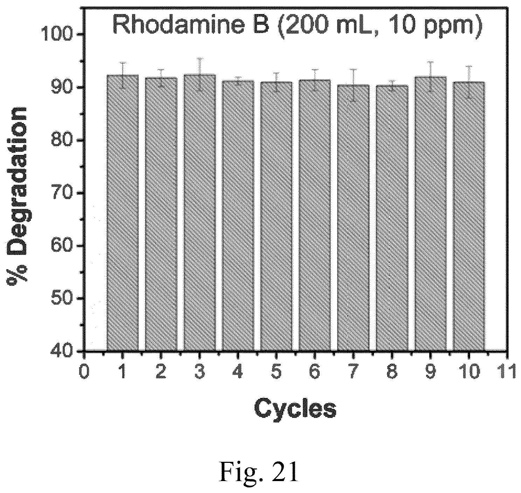

To assess lifetime of the MoS₂-PVDF film formed as in Example 1 the piezocatalysis test was repeated using the same film with fresh solution of Rhodamine B (200 mL, 10 ppm) on each repetition. The result presented in Figure 21 shows stable catalytic performance over 10 cycles with >90% efficiency using 200 mL of dye solution under dark conditions. This is in contrast to the work in reference [4] using a MoS₂ nanoflower/PDMS composite and which demonstrated catalytic activity which decreased with progressive cycles (67% at 4^{th} cycle) due to release of MoS₂ particles from PDMS surface. By contrast FESEM of the surface of the MoS₂-PVDF film formed as in Example 1 following the repeated piezocatalytic testing shows that structural integrity is maintained even after repeated use.

## Claims

1. A piezoelectric and piezocatalytic material comprising MoS₂ nanoflowers embedded throughout a body comprising poly vinylidene difluoride, PVDF.

2. A material according to claim 1, comprising up to 20 wt.% MoS₂ nanoflowers based on the weight of MoS₂ nanoflowers and PVDF.

3. A material according to claim 2, comprising 5-20 wt.% MoS₂ nanoflowers based on the weight of MoS₂ nanoflowers and PVDF.

4. A material according to any one of claims 1-3, wherein at least 70% of the material is PVDF.

5. A material according to any one of claims 1-4, wherein at least 60% by weight of the PVDF is β phase PVDF.

6. A material according to any one of claims 1-5, wherein the PVDF has a mass average molecular weight determined by gel permeation chromatography, GPC, in the range 50,000-800,000.

7. A flexible piezoelectric and piezocatalytic layer, coating or sheet formed from a material according to any one of claims 1-6.

8. A layer, coating or sheet according to claim 7, having a thickness up to 2 mm.

9. A method of piezocatalytic removal of contaminants from an aqueous environment, the method comprising contacting the aqueous environment with a material according to any one of claims 1-6, or a layer, coating or sheet according to claim 7 or 8, and applying mechanical stress to said material, layer, coating or sheet.

10. A method of generating piezoelectricity, the method comprising providing a material according to any one of claims 1-6, or a layer, coating or sheet according to claim 7 or 8, and applying mechanical stress to said material, layer, coating or sheet.

11. A method of forming a material according to any one of claims 1-6, the method comprising intimately mixing MoS₂ nanoflowers with PVDF in a solvent to form a mixture; and then removing the solvent from the mixture.

12. A method according to claim 11, which method does not include a step of electrospinning.

13. A method according to claim 11, which method does not include a poling step.

## Patentansprüche

1. Piezoelektrisches und piezokatalytisches Material, das MoS₂-Nanoblumen umfasst, die durchgehend in einem Körper eingebettet sind, der Polyvinylidendifluorid PVDF umfasst.

2. Material nach Anspruch 1, das auf Basis des Gewichts der MoS₂-Nanoblumen und des PVDF bis zu 20 Gew.-% MoS₂-Nanoblumen umfasst.

3. Material nach Anspruch 2, das bezogen auf das Gewicht der MoS₂-Nanoblumen und des PVDF 5 bis 20 Gew.-% MoS₂-Nanoblumen umfasst.

4. Material nach einem der Ansprüche 1 bis 3, wobei zumindest 70 % des Materials PVDF sind.

5. Material nach einem der Ansprüche 1 bis 4, wobei zumindest 60 Gew.-% des PVDF β-Phasen-PVDF sind.

6. Material nach einem der Ansprüche 1 bis 5, wobei das PVDF ein mittels Gelpermeationschromatographie GPC bestimmtes gewichtsmittleres Molekulargewicht im Bereich von 50.000 bis 800.000 aufweist.

7. Flexible piezoelektrische und piezokatalytische Schicht, Beschichtung oder Platte, die aus einem Material nach einem der Ansprüche 1 bis 6 besteht.

8. Schicht, Beschichtung oder Platte nach Anspruch 7, die eine Dicke von bis zu 2 mm aufweist.

9. Verfahren zur piezokatalytischen Entfernung von Verunreinigungen aus einer wässrigen Umgebung, wobei das Verfahren das In-Kontakt-Bringen der wässrigen Umgebung mit einem Material nach einem der Ansprüche 1 bis 6 oder einer Schicht, Beschichtung oder Platte nach Anspruch 7 oder 8 und das Anwenden von mechanischer Beanspruchung auf das Material, die Schicht, die Beschichtung oder die Platte umfasst.

10. Verfahren zur Erzeugung von Piezoelektrizität, wobei das Verfahren das Bereitstellen eines Materials nach einem der Ansprüche 1 bis 6 oder einer Schicht, Beschichtung oder Platte nach Anspruch 7 oder 8 und das Anwenden von mechanischer Beanspruchung auf das Material, die Schicht, die Beschichtung oder die Platte umfasst.

11. Verfahren zur Herstellung eines Materials nach einem der Ansprüche 1 bis 6, wobei das Verfahren das innige Vernischen von MoS₂-Nanoblumen mit PVDF in einem Lösungsmittel, um ein Gemisch zu bilden, und das anschließende Entfernen des Lösungsmittels aus dem Gemisch umfasst.

12. Verfahren nach Anspruch 11, wobei das Verfahren keinen Schritt des Elektrospinnens umfasst.

13. Verfahren nach Anspruch 11, wobei das Verfahren keinen Schritt des Polens umfasst.

## Revendications

1. Matériau piézoélectrique et piézocatalytique comprenant des nanofleurs de MoS₂ incorporées dans tout un corps comprenant du polydifluorure de vinylidène (PVDF).

2. Matériau selon la revendication 1, comprenant jusqu'à 20 % en poids de nanofleurs de MoS₂ sur la base du poids des nanofleurs de MoS₂ et du PVDF.

3. Matériau selon la revendication 2, comprenant 5 à 20 % en poids de nanofleurs de MoS₂ sur la base du poids des nanofleurs de MoS₂ et du PVDF.

4. Matériau selon l'une quelconque des revendications 1 à 3, dans lequel au moins 70 % du matériau est du PVDF.

5. Matériau selon l'une quelconque des revendications 1 à 4, dans lequel au moins 60 % en poids du PVDF est du PVDF de phase β.

6. Matériau selon l'une quelconque des revendications 1 à 5, dans lequel le PVDF présente un poids moléculaire moyen en masse déterminé par chromatographie par perméation de gel, GPC, dans la plage de 50 000 à 800 000,

7. Couche, revêtement ou feuille piézoélectrique et piézocatalytique flexible formé(e) à partir d'un matériau selon l'une quelconque des revendications 1 à 6.

8. Couche, revêtement ou feuille selon la revendication 7, présentant une épaisseur allant jusqu'à 2 mm.

9. Procédé d'élimination piézocatalytique de contaminants à partir d'un environnement aqueux, le procédé comprenant une mise en contact de l'environnement aqueux avec un matériau selon l'une quelconque des revendications 1 à 6, ou une couche, un revêtement ou une feuille selon la revendication 7 ou 8, et une application d'une contrainte mécanique audit matériau, à ladite couche, audit revêtement ou à ladite feuille.

10. Procédé de génération de piézoélectricité, le procédé comprenant une fourniture d'un matériau selon l'une quelconque des revendications 1 à 6, ou d'une couche, d'un revêtement ou d'une feuille selon la revendication 7 ou 8, et une application d'une contrainte mécanique audit matériau, à ladite couche, audit revêtement ou à ladite feuille.

11. Procédé de formation d'un matériau selon l'une quelconque des revendications 1 à 6, le procédé comprenant le mélange intime de nanofleurs de MoS₂ avec du PVDF dans un solvant pour former un mélange ; puis l'élimination du solvant à partir du mélange.

12. Procédé selon la revendication 11, lequel procédé ne comprend pas d'étape d'électrofilage.

13. Procédé selon la revendication 11, lequel procédé ne comprend pas d'étape de polarisation,
